(19) Europäisches Patentamt
European Patent Office
Office européen des brevets

(11) Publication number: **0 237 255 A2**

# (12) EUROPEAN PATENT APPLICATION

(21) Application number: 87301854.3

(22) Date of filing: 03.03.87

(51) Int. Cl.³: C 08 L 63/00
C 08 L 61/02, C 08 L 25/18
C 08 L 79/08, H 01 B 3/30

(30) Priority: 07.03.86 JP 48348/86

(43) Date of publication of application:
16.09.87 Bulletin 87/38

(84) Designated Contracting States:
DE FR GB

(71) Applicant: HITACHI, LTD.
6, Kanda Surugadai 4-chome
Chiyoda-ku Tokyo 101(JP)

(72) Inventor: Nishikawa, Akio
13-21, Oomika-cho 6-chome
Hitachi-shi Ibaraki 319-12(JP)

(72) Inventor: Koyama, Toru
6-6, Suwa-cho 1-chome
Hitachi-shi Ibaraki 316(JP)

(72) Inventor: Kanno, Chikashi
17-13, Ishinazaka-cho 1-chome
Hitachi-shi Ibaraki 319-12(JP)

(72) Inventor: Shibata, Nobuo
13-20, Moriyama-cho 2-chome
Hitachi-shi Ibaraki 316(JP)

(72) Inventor: Wajima, Motoyo
8-8, Higashi Oonuma-cho 1-chome
Hitachi-shi Ibaraki 316(JP)

(72) Inventor: Tada, Ritsuro
604-26, Senba-cho
Mito-shi Ibaraki 310(JP)

(72) Inventor: Narahara, Toshikazu
409-5, Muramatsu Toukai-mura
Naka-gun Ibaraki 319-11(JP)

(74) Representative: Stuart, Ian Alexander et al,
MEWBURN ELLIS & CO. 2/3 Cursitor Street
London EC4A 1BQ(GB)

## (54) Curable resin compositions and semiconductor devices coated and sealed with the same.

(57) A thermosetting resin composition comprising at least a cycloaliphatic ether oligomer represented by the general formula (I):

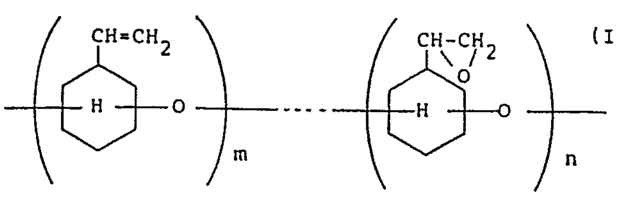

(I)

wherein m and n are each 0 to 30 and $2<m+n\leq 30$, and 2,4-diamino-6-vinyle-s-triazine, a crosslinking agent. The thermosetting resin composition is suitable for coating and sealing semiconductor device and improves heat resistance, humidity resistance and migration resistance of the semiconductor device coated and sealed thereby.

EP 0 237 255 A2

# CURABLE RESIN COMPOSITIONS AND SEMICONDUCTOR DEVICES COATED AND SEALED WITH THE SAME

The present invention relates to curable resin compositions. A preferred embodiment is a thermo and/or light curable resin composition which is excellent in heat resistance, humidity resistance and moldability and contains a reduced amount of ionic impurities. The invention also relates to a semiconductor device coated and sealed with the resin composition.

In the field of electrical apparatus, electronic parts and the like, reduction in size and weight, enhancement in performance and reliability and diversification of function are currently required. Therefore, a resin system which is excellent in heat resistance, humidity resistance, electrical insulation properties, adhesion properties, weathering resistance and moldability and contains a reduced amount of ionic impurities has been highly desired as an insulation material, laminating material, sealing material, coating material, adhesive or varnish for such apparatus or parts. Since the use environment of a resin-sealed semiconductor device has become more severe with enlarging fields of application thereof, the performance and

reliability of the device is highly dependent upon the characteristics of a coating or sealing material used for protection and insulation of a semiconductor element.

Up to this time, an epoxy resin composition has been used as the insulating, laminating, coating or sealing material. An epoxy resin which is now generally used is prepared by the reaction of epichlorohydrin with bisphenol A or phenolic novolak. However, the former has problems in heat resistance and electrical characteristics, while the latter contains several tens of ppm of ionic chlorine, so that it has a problem that metallic wires on an LSI element tend to corrode, thus resulting in breakage.

Although a cycloaliphatic epoxy resin is known as an epoxy resin which is excellent in heat resistance and electrical characteristics, free from ionic chlorine and is generally cured with a carboxylic acid anhydride under heating, it is highly toxic and exhibits a poor reactivity, so that it is applied only to a limited field such as varnish.

The above epoxy resin compositions of the prior art have each both advantages and disadvantages and do not sufficiently satisfy the above demand that heat resistance, humidity resistance, electrical insulation properties, adhesion properties, weathering resistance and moldability be all excellent and the content of ionic impurities be low.

The present invention has been accomplished under these circumstances. It is desirable to provide a curable resin composition excellent in heat resistance, humidity resistance, electrical insulation properties, adhesion properties, weathering resistance, moldability and migration resistance, and containing a reduced amount of ionic impurities.

It is also desirable to provide a semiconductor device sealed with this resin composition.

The first aspect of the present invention resides in a curable resin composition comprising at least a cycloaliphatic ether oligomer represented by the general formula (I):

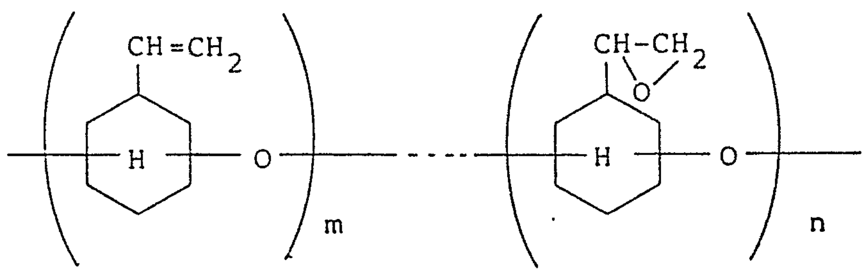

(I)

wherein m and n are each 0 to 30 and $2 < m+n \leq 30$, and a crosslinking agent, wherein the crosslinking agent is selected from:

a phenolic resin represented by the general formula (II):

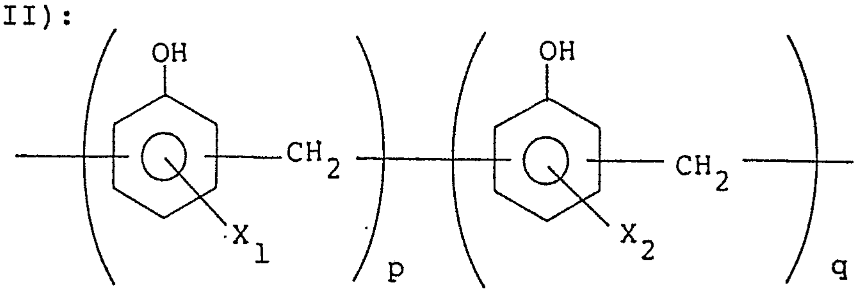

(II)

wherein $X_1$ and $X_2$ may be the same or different from each other and each stands for H, $CH_3$, $C(CH_3)_3$, OH, $NH_2$, COOH, SH, $SO_3H$, $CH_2OH$, Br, Cl,

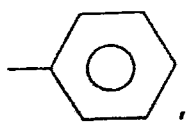 , 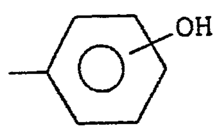 , 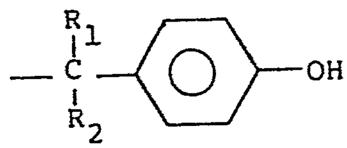

(wherein $R_1$ and $R_2$ are H, $CH_3$ or $CF_3$) and p and q are each 0 to 10 and $1 < p+q \leq 10$;

a p-hydroxylstyrene polymer or copolymer represented by the general formula (III):

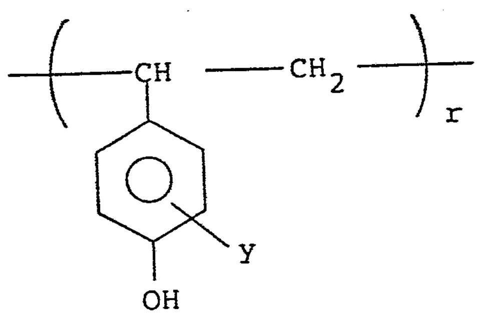 (III)

wherein y is H, $NH_2$, $SO_3H$, Br or Cl and r is 5 to 300;

a compound having at least one N-substituted maleimide bonding or a Diels-Alder adduct thereof;

a compound having at least one allyl or propenyl group and at least one hydroxyl group; or

2,4-diamino-6-vinyl-s-triazine.

The second aspect of the present invention resides in a semiconductor device obtained by coating and sealing at least a part of a semiconductor element and a lead

wire with the curable resin composition explained above. Preferably the curable resin composition comprises at least a cycloaliphatic ether oligomer represented by the general formula (I):

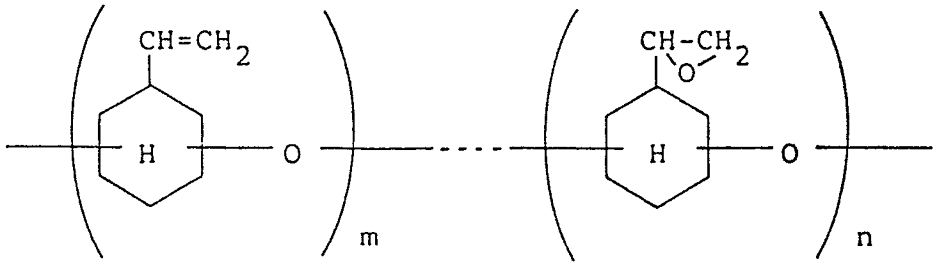

(I)

wherein m and n are each 0 to 30 and $2<m+n\leq 30$, and a crosslinking agent of 2,6-diamino-6-vinyl-s-triazine.

The cycloaliphatic ether oligomer represented by the general formula (I) to be used in the present invention may be prepared by a process described in Japanese Patent Laid-Open Nos. 161939/1985, 166675/1985, 170620/1985 and US Patent No. 4,565,859.

For example, a cycloaliphatic ether oligomer represented by the general formula:

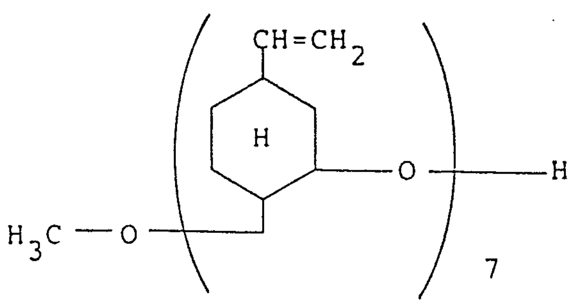

is prepared by reacting 1 mol of methanol with 7 mol of vinylcyclohexane monoepoxide in the presence of $BF_3O(C_2H_5)$ catalyst at 60°C for 12 hours.

Alternatively, a cycloaliphatic allyl vinyl ether oligomer represented by the general formula:

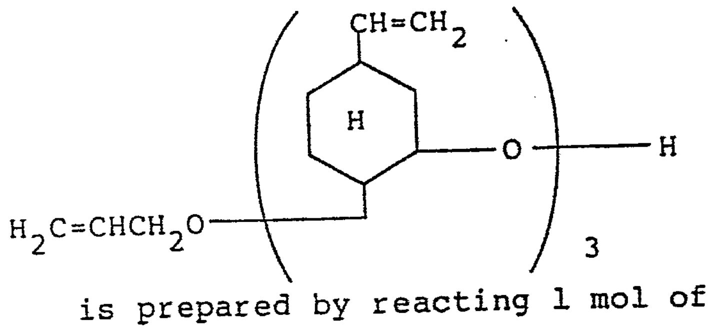

is prepared by reacting 1 mol of allyl alcohol with 3 mol of vinylcyclohexene monoxide under substantially the same condition as the one described above.

The above cycloaliphatic ether oligomer, a cyclohexene oxide polymer having pendant vinyl groups, is converted to an epoxy resin through the peracetic acid process using peracid or hydroperoxide under the presence of an alkali or acid catalyst.

Some of the oligomers are commercially available as a product of Daicel Chemical Industries Ltd. Examples thereof are as follows:

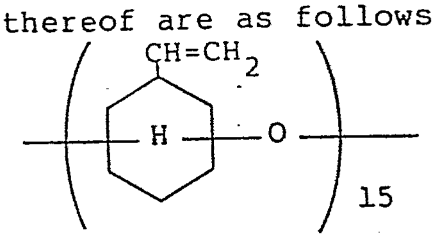

HPE-3150

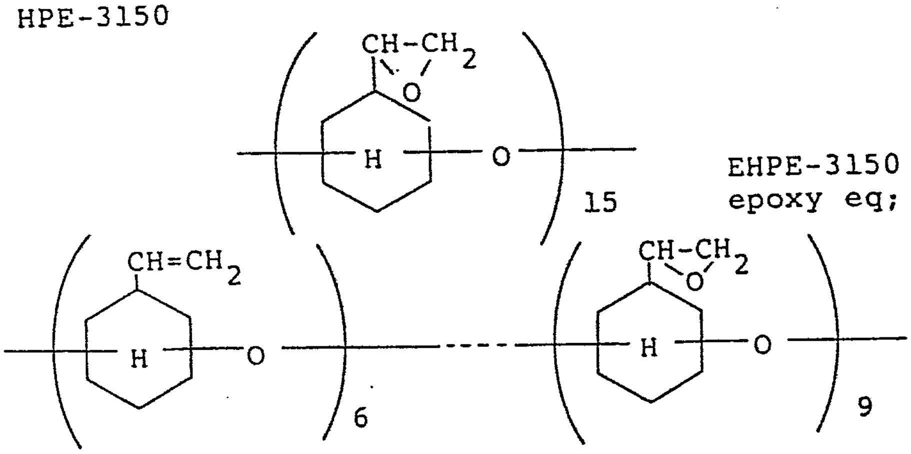

EHPE-3150 m.p.;71°C, epoxy eq; 179

EHPE-3156 m.p.;63°C, epoxy eq; 258

The EHPE-3150 and EHPE-3156 group epoxy compounds are free from ionic chlorine and are more excellent in reactivity and heat resistance than the cycloaliphatic epoxy compounds of the prior art.

Examples of phenolic resin crosslinking agents represented by the general formula (II):

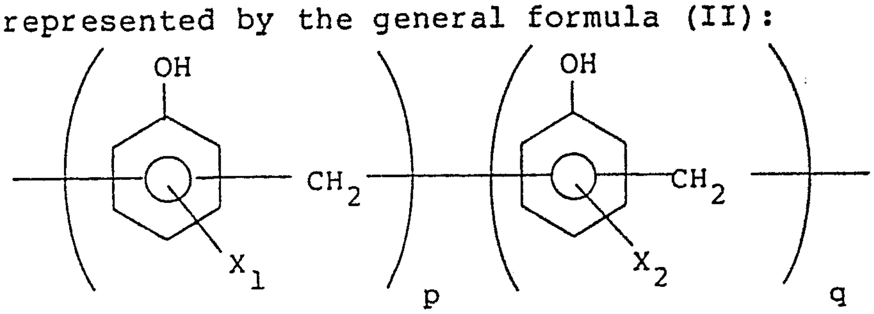 (II)

wherein $X_1$ and $X_2$ may be the same or different from each other and each stands for H, $CH_3$, $C(CH_3)_3$, OH, $NH_2$, COOH, SH, $SO_3H$, $CH_2OH$, Br, Cl,

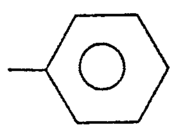 , 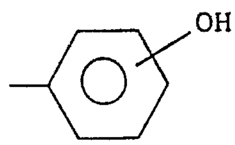 , 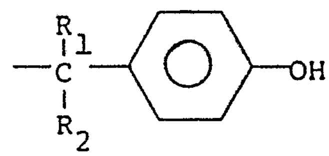

(wherein $R_1$ and $R_2$ are H, $CH_3$ or $CF_3$) and p and q are 0 to 10 and $1 < p+q \leq 10$,

are condensates prepared by condensing phenol, o-cresol, biphenol, bisphenol F, bisphenol A or trifluoromethylbisphenol A with formaldehyde in the presence of an acid catalyst such as hydrochloric or oxalic acid. The above phenolic resin may be modified with melamine, urea, resorcinol, catechol or hydroquinone. Particularly, a condensate of biphenol with formaldehyde is effective in imparting heat resistance.

Examples of p-hydroxylstyrene polymer or copolymer crosslinking agents represented by the general formula (III):

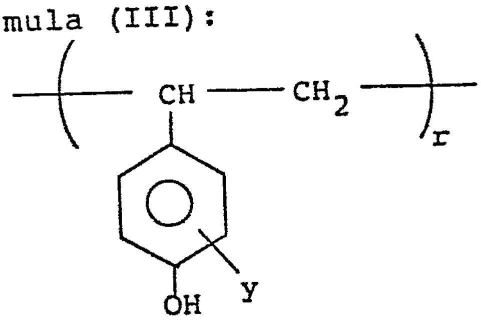

(III)

wherein y is H, $NH_2$, $SO_3H$, Br or Cl and r is 5 to 300,

are p-hydroxylstyrene polymer (for example, ones having a number-average molecular weight of 800 to 20,000 are commercially available as a product of Maruzen Petrochemical Co. Ltd., M-Resin or MB-Resin), 4-hydroxy-4'-biphenylvinyl polymer and copolymers of p-hydroxylstyrene or 4-hydroxy-4'-biphenylvinyl with styrene, maleic acid, butadiene or maleimide.

Examples of compounds having at least one N-substituted maleimide bonding or a Diels-Alder adduct thereof useful as crosslinking agents are N-substituted phenylmaleimide and compounds represented by the formula:

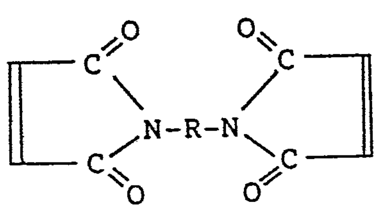

wherein R stands for an alkylene or arylene group or bivalent organic groups substituted thereby,

examples of the latter compounds include N,N'-ethylenebismaleimide, N,N'-hexamethylenebismaleimide, N,N'-dodecamethylenebismaleimide, N,N'-m-phenylene-bismaleimide, N,N'-4,4'-diphenyl ether bismaleimide, N,N'-4,4'-diphenylmethane bismaleimide, N,N'-4,4'-dicyclohexylmethane bismaleimide, N,N'-4,4'-m-xylene bismaleimide, N,N'-4,4'-diphenylcyclohexane bismaleimide and N,N'-2,2-bis[4-(4-aminophenoxy)phenyl] propane bismaleimide. A mixture of two or more of these compounds may be also used. Further, a mixture of the above N,N'-substiuted bismaleimide with mono-, tri-or tetrasubstituted maleimide may be used. Furthermore, adducts of the above maleimide with cyclopentadiene, furan, amine, hydroxyl or thiocol compound may be used.

Examples of compounds having at least one allyl or propenyl group and at least one hydroxyl group useful as crosslinking agents are

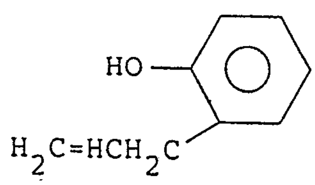

and

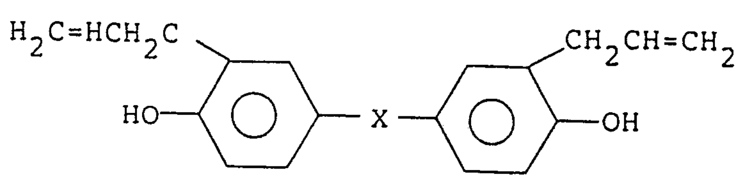

wherein -X- is an isopropylene or methylene group, -O- or none.

Particularly, the crosslinking agent which constitutes the curable resin composition for coating and sealing at least a part of a semiconductor element and a lead wire together with a cycloaliphatic ether oligomer represented by the general formula (I):

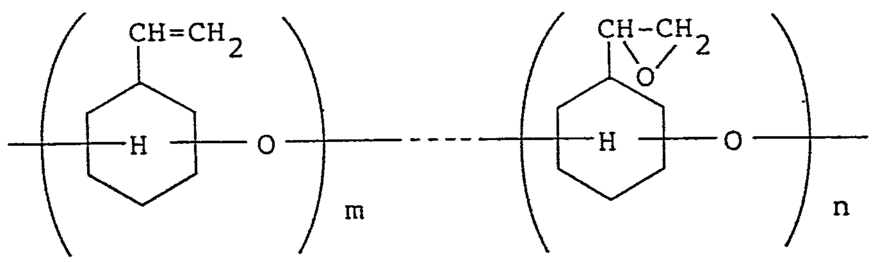

(I)

wherein m and n are each 0 to 30 and $2 < m+n \leq 30$, is preferably 2,4-diamino-6-vinyl-s-triazine, because it is effective in controlling both the corrosion of an aluminum wire on an LSI element and the migration of Cu, Ag or Au to thereby enhance the reliability of a semiconductor device.

The curable resin composition according to the present invention may further contain a known epoxy resin. Examples of such an epoxy resin include compounds having two functional groups, such as diglycidyl ether of bisphenol A, butadiene diepoxide, 3,4-epoxy cyclohexylmethyl-(3,4-epoxy) cyclohexanecarboxylate, vinylcyclohexane dioxide, 4,4'-di(1,2-epoxyethyl)diphenyl ether, 4,4'-(1,2-epoxyethyl)-biphenyl, 2,2'-bis(3,4-epoxycyclohexyl)propane, glycidyl ether of resorcinol, diglycidyl ether of phloroglucinol, diglycidyl ether of

methylphloroglucinol, bis (2,3-epoxycyclopentyl) ether, 2-(3,4-epoxy)cyclohexane-5, 5-spiro(3,4-epoxy)cyclohexane-m-dioxane, bis(3,4-epoxy-6-methylcyclo-hexyl) adipate and N,N'-m-phenylenebis (4,5-epoxy-1,2-cyclohexane)dicarboxyimide and compounds having three or more functional groups, such as triglycidyl ether of p-aminophenol, polyallyl glycidyl ether, 1,3,5-tri(1,2-epoxyethyl)benzene, 2,2', 4,4'-tetraglycidoxybenzophenone, tetraglycidoxytetraphenylethane, polyglycidyl ether of phenolic formaldehyde novolak, triglycidyl ether of glycerin and triglycidyl ether of trimethylolpropane. The above epoxy compounds can be used alone or as an admixture depending upon the use or the object.

The above epoxy resins are used together with a crosslinking agent. Compounds useful as such a crosslinking agent are described, for example, in Hiroshi Kakiuchi, "Epoxy Resins" pages 109 to 149 (September, 1970); Lee, Neville, "Epoxy Resins" (McGraw-Hill Book Company Inc., New York), pages 63 to 140 (1957) and P.E. Brunls, "Epoxy Resins Technology" (Inter Science Publishers, New York), pages 45 to 109 (1968). Examples of the crosslinking agent include amines including aliphatic polyamines, aromatic polyamines, and secondary or tertiary amines; carboxylic acids and anhydrides thereof; oligomers and polymers of aliphatic or aromatic polyamides; complexes of boron trifluoride with amines; precondensates of synthetic resins such as phenolic,

melamine, urea or urethane resin; dicyandiamide; benzoganamine; carboxylic acid hydrazide and polyaminomaleimides. The above crosslinking agents may be used alone or as an admixture depending upon the use and the object.

The curable resin composition of the present invention may further contain a known catalyst which promotes the reaction between the cycloaliphatic ether oligomer represented by the general gormula (I) and the crosslinking agents. Examples of the catalyst include tertiary amines such as triethanolamine, tetramethylbutanediamine, tetramethylpentanediamine, tetramethylhexanediamine, triethylenediamine and dimethylaniline; hydroxylalkylamines such as dimethylaminoethanol and dimethylaminopentanol and amines such as tris(dimethylaminomethyl)phenol and methylmorpholine; quaternary ammonium salts such as cetyltrimethylammonium bromide, cetyltrimethylammonium chloride, dodecyltrimethylammonium iodide, trimethyldodecylammonium chloride, benzyldimethyltetradecylammonium chloride, benzylmethylpalmitylammonium chloride, allyldodecyltrimethylammonium bromide, benzyldimethylstearylammonium bromide, stearyltrimethylammonium chloride and benzyldimethyltetradecylammonium acetate; imidazole compounds such as 2-undecylimidazole, 2-methylimidazole, 2-ethylimidazole, 2-heptadecylimidazole, 2-methyl-4-ethylimidazole, 1-butylimidazole, 1-propyl-2-

methylimidazole, 1-benzyl-2-methylimidazole, 1-cyanoethyl-2-methylimidazole, 1-cyanoethyl-2-undecylimidazole, 1-cyanoethyl-2-phenylimidazole, 1-azine-2-methylimidazole and 1-azine-2-undecylimidazole; tetraphenylborates such as triphenylphosphine tetraphenylborate, triethylamine tetraphenylborate, N-methylmorpholine tetraphenylborate, pyridine tetraphenylborate, 2-ethyl-4-methylimidazole tetraphenylborate and 2-ethyl-1,4-dimethylimidazole tetraphenylborate.

The above catalyst may be used alone or as an admixture, while the amount thereof may be 0.01 to 20% by weight based on the amount of the cycloaliphatic ether oligomer represented by the general formula (I).

The curable resin composition according to the present invention may further contain polymerizable monomer with ethylenical unsaturated bonds depending upon the use and the object thereof. Examples of the monomer include styrene, vinyltoluene, α-methylstyrene, divinylbenzene, diallyl phthalate, diallyl phthalate prepolymer, chlorostyrene, dichlorostyrene, bromostyrene, dibromostyrene, diallyl benzenephosphonate, diallyl arylphosphinate, acrylic acid, acrylate, methacrylate, epoxy acrylate, triallyl cyanurate, tribromophenol allyl ether, unsaturated polyester and polybutadiene.

A catalyst which is effective in accomplishing the crosslinking of the above monomers may further contain in the curable resin composition. One or more organic

peroxide may be used as such a catalyst. Examples of the organic peroxide include benzoyl peroxide, p-chlorobenzoyl peroxide, 2,4-dichlorobenzoyl peroxide, capryl peroxide, lauroyl peroxide, acetyl peroxide, methyl ethyl ketone peroxide, cyclohexanone peroxide, bis(1-hydroxycyclohexyl peroxide), hydroxyheptyl peroxide, t-butyl hydroperoxide, p-menthane hydroperoxide, cumene hydroperoxide, 2,5-dimethylhexyl-2,5-dihydroxide, di-t-butyl peroxide, dicumyl peroxide, 2,5-dimethyl-2,5-di(t-butylperoxy)hexane, 2,5-dimethylhexyl-2,5-di(peroxybenzoate), t-butyl perbenzoate, t-butyl peracetate, t-butyl peroctoate, t-butyl peroxyisobutyrate and di-t-butyl di-perphthalate.

The curable resin composition according to the present invention may further contain a powdery or short-fibrous filler such as calcium stearate, silica, alumina, titania, aluminum hydroxide, aluminum silicate, zirconium silicate, zircon, glass, talc, mica, graphite, aluminum, copper or iron; a mold releasing agent such as fatty acid or wax; a coupling agent such as epoxysilane, vinylsilane, borane, alkyl titanate or metal chelate or a flame retarder such as antimony, phosphorus compound or halogen-containing compound.

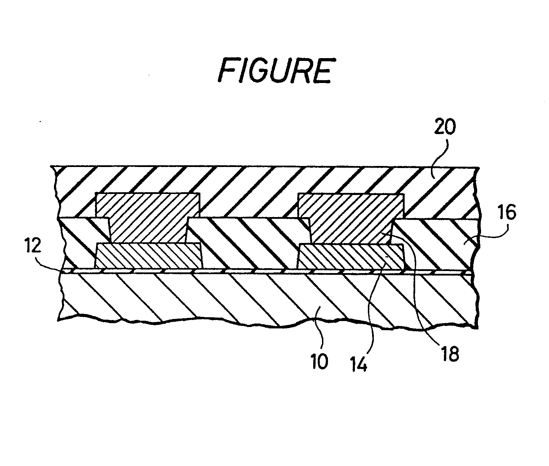

Some preferred embodiments of the invention will now be described with reference to the drawing, whereof the sole figure shows a schematic sectional view of a part of a semiconductor device.

Examples 1 to 6

100 parts by weight of EHPE-3150 (a product of Daicel Chemical Industries Ltd., melting point: 71°C, epoxy equivalent: 179) represented by the formula:

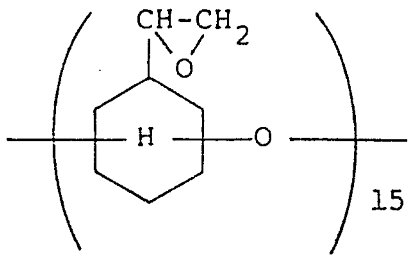

or a mixture thereof with 100 parts by weight of EHPE-3156 (a product of Daicel Chemical Industries Ltd., melting point: 63°C, epoxy equivalent: 258, iodine value: 72) represented by the formula:

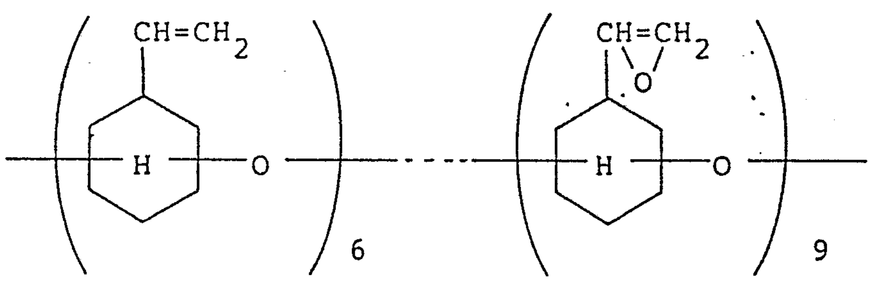

was used as a cycloaliphatic ether oligomer and a crosslinking agent and additives shown in Table 1 were added thereto.

The amounts of crosslinking agents and additives are indicated in parts by weight.

The employed crosslinking agents are, condensate of bisphenol A with formalin represented by the formula:

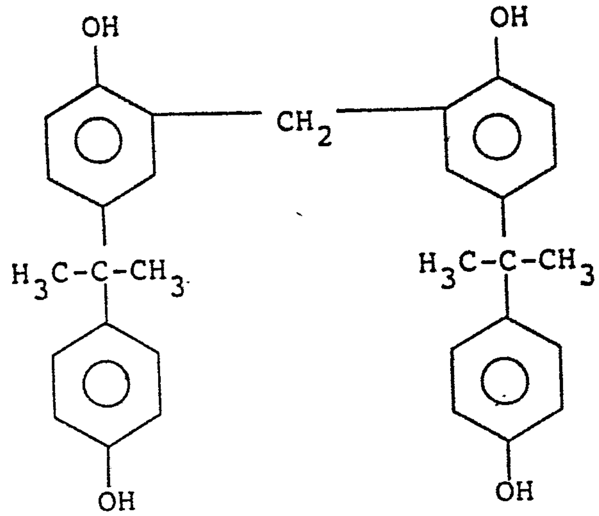

;

condensate of fluorinated bisphenol A with formalin (both are products of Dainippon Ink & Chemicals, Inc.); p-hydroxylstyrene polymer, Maruzen M Resin (molecular weight: 4800); compound having an N-substituted maleimide bonding, N,N-4,4'-diphenylmethane bismaleimide (a product of Mitsui Toatsu Chemicals, Inc.); and phenolic novolak HP-607N (a product of Hitachi Chemical Co., Ltd.). These crosslinking agents were each added to the above oligomer in a given amount as indicated in Table 1 to prepare six compositions. Further, 2 parts by weight of triethylamine tetraphenyl-borate, a curing accelerator, 2 parts by weight of epoxy-silane KBM 303, a coupling agent (a product of the Shin-etsu Chemical Co., Ltd.), 2 parts by weight of Hoechst wax E, a mold releasing agent (a product of Hoechst Japan Co., Ltd.), 4 parts by weight of red phosphorus coated with an imide of addition type, a flame

retarder, a given amount of a molten quartz glass powder, a filler and 2 parts by weight of carbon black, a coloring material (a product of Cabot Corporation) were added to each of the six compositions.

The obtained compositions were each kneaded by a twin roll having a diameter of 8 inch at 70 to 80°C for 8 minutes and powdered coarsely to obtain compositions for the sealing of LSI.

Each of the compositions was examined for heat resistance (glass transition temperature), high-temperature strength (flexural strength ($kgf/cm^2$) at 180°C) and storage stability at room temperature.

Further, fifty LSI's having a memory of 256 kbit (D-RAM) were sealed with each of the compositions by transfer molding (180°C, 70 $kgf/cm^2$ and 2 minutes) to obtain resin-sealed semiconductor devices. The devices were examined for humidity resistance.

The evaluation of the humidity resistance was carried out by placing the resin-sealed LSI in an atmosphere supersaturated with water vapor of 2 atm and 121°C for a given period and examining electrically the LSI for breakage of its aluminum wire.

Table 1

| Item | | Example | 1 | 2 | 3 | 4 | 5 | 6 |
|---|---|---|---|---|---|---|---|---|
| Epoxy Resins | EHPE 3150 | | 100 | 100 | 100 | 100 | 100 | 100 |
| | EHPE 3156 | | | | | | 100 | 100 |
| Cross-linking agents | condensate of bisphenol A with formalin | | 56 | | | | | |
| | condensate of fluorinated bisphenol A with formalin | | | 58 | | | | |
| | M Resin | | | | 60 | | | |
| | N,N-4,4'diphenylmethane bismaleimide | | | | | 55 | 40 | 55 |
| | phenolic novolak HP607N | | | | | | 39 | |
| Filler: | molten quartz glass powder | | 468 | 474 | 480 | 465 | 537 | 465 |
| Characteristics | glass transition temperature (°C) | | 236 | 257 | 310 | 312 | 266 | 284 |
| | flexural strength ($kgf/cm^2$) | | 510 | 557 | 590 | 650 | 580 | 550 |
| | storage stability at room temperature, 25°C | | more than 3 months | " | " | " | " | " |
| | humidity resistance degree of breakage of aluminum wire (%) | 1000 h | 0 | 0 | 0 | 0 | 0 | 0 |
| | | 1500 h | 0 | 0 | 0 | 0 | 0 | 0 |
| | | 2000 h | 0 | 0 | 0 | 0 | 0 | 0 |
| | | 2500 h | 0 | 0 | 3 | 0 | 7 | 11 |
| | | 3000 h | 5 | 1 | 17 | 6 | 20 | 45 |
| | migration resistance | | G | G | G | G | G | G |

G : good

Example 7

A mixture comprising 50 parts by weight of a polyfunctional epoxy compound derived from tris(hydroxyphenyl)-methane; XD-9053 (a product of Dow Chemical Co., epoxy equivalent: 225), 50 parts by weight of EHPE 3150, 18 parts by weight of 2,4-diamino-6-vinyl-s-triazine, a crosslinking agent, 2 parts by weight of triphenylphosphine, a curing accelerator, 2 parts by weight of epoxysilane KBM303, a coupling agent (a product of The Shin-etsu Chemical Co., Ltd.), 4 parts by weight of red phosphorus coated with an imide of addition type, a flame retarder, a mold releasing agent comprising 1 part by weight of calcium stearate and 1 part by weight of Hoechst wax E (a product of Hoechst Japan Co., Ltd.), 75% by weight of a molten quartz glass powder, a filler and 2 parts by weight of carbon black, a coloring material (a product of Cabot Corporation) was kneaded by a twin roll having a diameter of 8 inch at 70 to 80°C for 7 minutes and powdered coarsely to obtain a resin composition for sealing of a semiconductor.

The obtained resin composition was fed in to a transfer molding machine fitted with a mold, in which LSI elements having a D-RAM, memory of 256 kbit were placed, at 180°Cwith 70 kgf/cm$^2$ for 1.5 minute.

The obtained resin-sealed semiconductor device were placed in an atmosphere supersaturated with water vapor of 121°C and 2 atm (PCT) and checked electrically after every given period.

No breakage of the aluminum wire due to corrosion was observed even after 3000 hours. Further, the migration resistance was remarkably excellent.

Examples 8-10

250 ml of methyl ethyl ketone was placed in a 500-ml conical flask, followed by the addition of 10 parts by weight of EHPE3150, EHPE3156 or HPE3150 (a product of Daicel Chemical Industries Ltd.) which were indicated previously.

Further, Kerimid K601 (an adduct of bismaleimide with amine, a product of Rhone-Poulenc Corp.) and, if necessary, an aluminum chelate coupling agent ALCH-TR (a product of Kawaken Fine Chemical Co., Ltd.) were added each in a given amount to the flask as indicated in Table 2 in parts by weight to obtain a coating composition.

The obtained coating composition was dropwise applied to LSI elements (16 pin) having a D-RAM, memory of 256 kbit and lead wires (including a wire bonding), followed by heating at 100°C for 1 hour, at 200°C for 1 hour and at 250°C for 30 minutes, thus forming a coating film having a thickness of 30 to 60 μm on the elements and the like.

The above LSI element coated with the resin composition of the present invention were sealed with a conventional epoxy resin composition, which will be described below, by transfer molding (180°C, 70 kg/$cm^2$

and 1.5 minute) to obtain resin-sealed semiconductor devices. With respect to each case, one hundred LSI's were examined for humidity resistance. The results are shown in Table 2. For comparison, the results with respect to the LSI elements coated with a resin containing no cycloaliphatic ether oligomers are shown in Table 2 as a Comparative Example.

Table 2

| Item \ Example | | | 8 | 9 | 10 | Comparative Example |
|---|---|---|---|---|---|---|
| Coating Compositions | EHPE 3150 | | 10 | - | - | - |
| | EHPE 3156 | | - | 10 | - | - |
| | HPE 3150 | | - | - | 10 | - |
| | Kerimid K-601 | | 15 | 15 | 15 | 25 |
| | aluminum chelate ALCH-TR | | - | - | 0.50 | 0.50 |
| Humidity resistance degree of breakage of aluminum wire due to corrosion (%) | Standing time in PCT (h) | 1000 | 0 | 0 | 0 | 5 |
| | | 1500 | 0 | 0 | 0 | 26 |
| | | 2000 | 3 | 4 | 12 | 83 |
| | | 2500 | 15 | 18 | 30 | - |

The above indicated conventional epoxy resin composition for sealing the LSI elements was prepared as follows;

A mixture comprising 100 parts by weight of a polyfunctional epoxy compound derived from tris(hydroxyphenyl)methane; XD-9053 (a product of Dow Chemical Co., epoxy equivalent: 225), 55 parts by weight of a phenolic novolak, a crosslinking agent (a product of Hitachi Chemical Co., Ltd., softening point: 83°C), 3 parts by weight of triethylamine tetraphenylborate TEA-K, a curing accelerator, 2 parts by weight of epoxysilane KBM303, a coupling agent (a product of The Shin-etsu Chemical Co., Ltd.), 5 parts by weight of red phosphorus coated with an imide of addition type, a flame retarder, a mold releasing agent comprising 1 part by weight of calcium stearate and 1 part by weight of Hoechst wax E (a product of Hoechst Japan Co., Ltd.), 490 parts by weight of a molten quartz glass powder, a filler and 2 parts by weight of carbon black, a coloring material (a product of Cabot Corporation) were kneaded by a twin roll having a diameter of 8 inch at 70 to 85°C for 7 minutes and powdered coarsely to obtain an objective resin composition for sealing the LSI elements.

Examples 11 to 17

100 parts by weight of a cycloaliphatic ether epoxy compound EHPE3150 (a product of Daicel Chemical Industries

Ltd., epoxy equivalent: 179) was mixed with crosslinking agents such as 2,4-diamino-6-vinyl-s-triazine (a product of Shikoku Chemical Corporation, trade name: VT); intermolecular compound of VT with isocyanuric acid (a product of Shikoku Chemical Corporation, trade name: VT.ICA); 2,4-dihydrazino-6-methylamino-s-triazine (a product of Nippon Hydrazine Industry Co., Ltd., trade name: 24-HT); 3,9-bis[2-(3,5-diamino-2,4,6-triazaphenyl)ethyl]-2,4,8,10-tetraoxaspiro[5,5]undecane (a product of Ajinomoto Co., Inc., trade name: CTU guanamine) represent by the formula:

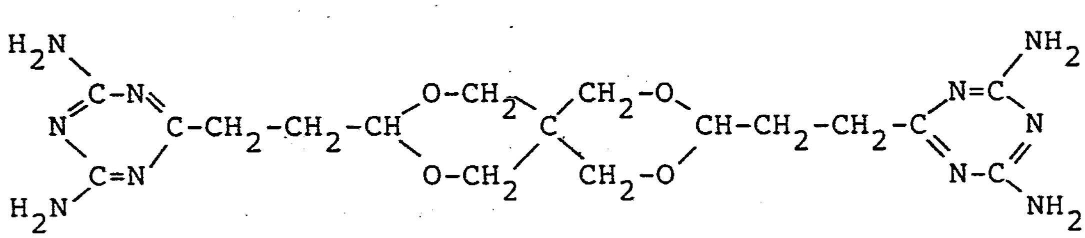

;

1,3-bis(hydrazinocaboethyl)-5-isopropylhydantoin (a product of Ajinomoto Co., Inc., trade name: Amicure Val DH, MW: 341, H-equivalent: 78.5, m.p.: 123 to 125°C) represented by the formula:

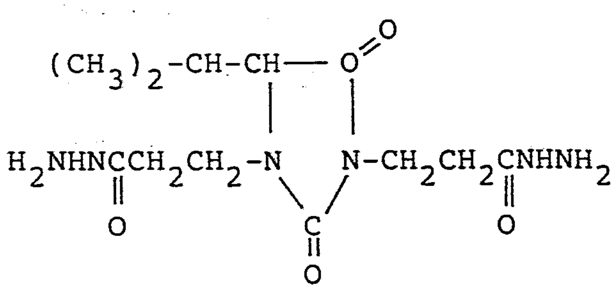

;

Amicure SL-20DH (a product of Ajinomoto Co., Inc., MW: 370, H-equivalent: 93, m.p.: 173 to 178°C) represented by the formula;

$$H_2NNHCO(CH_2)_{18}CONHNH_2$$ ;

and tetrahydrophthalic anhydride THPA, each in an amount given in Table 3 in parts by weight to obtain seven compositions. Further, 2.5 parts by weight of triphenylphosphine P-100, a curing accelerator, 2 parts by weight of epoxysilane KBM 403, a coupling agent (a product of The Shinetsu Chemical Co., Ltd.), 5 parts by weight of red phosphorus coated with an imide of addition type, a flame retarder, a given amount of a molten quartz glass powder, a filler, 2 parts by weight of carbon black, a coloring material (a product of Cabot Corporation) and a mold releasing agent comprising 1 part by weight of calcium stearate and 1 part by weight of Hoechst wax E (a product of Hoechst Japan Co., Ltd.) were added to each of the seven compositions.

The obtained compositions were each kneaded by a twin roll heated at 75 to 85°C for 7 minute, cooled and powdered coarsely to obtain a resin composition for the sealing of a semiconductor.

LSIs having a D-RAM, memory of 256 kbit were sealed with the obtained compositions under the same conditions as those used in Example 1 and the obtained resin-sealed LSIs were examined for humidity resistance under the ame conditions as those used in Example 1. The results are shown in Table 3.

Table 3

| Item \ Example | | 11 | 12 | 13 | 14 | 15 | 16 | 17 |
|---|---|---|---|---|---|---|---|---|
| Epoxy Resin | EHPE 3150 | 100 | 100 | 100 | 100 | 100 | 100 | 100 |
| Crosslinking agents | VT | 19 | - | - | - | - | - | - |
| | VT·ICA | - | 37 | - | - | - | - | 9.5 |
| | 24-HT | - | - | 26 | - | - | - | - |
| | CTU guanamine | - | - | - | 30 | - | - | - |
| | Amicure ValDH | - | - | - | - | 43 | - | - |
| | Amicure SL-20DH | - | - | - | - | - | 52 | - |
| | tetrahydrophathalic anhydride THPA | - | - | - | - | - | - | 21 |
| Crack generation after 1000 heating-coolingcycles (-198°C ⇄ 150°C ) | | no | " | " | " | " | " | " |
| Humidity resistance degree of breakage of aluminum wire due to corrosion (%) | 1000h | 0 | 0 | 0 | 0 | 0 | 0 | 0 |
| | 1500h | 0 | 0 | 0 | 0 | 0 | 0 | 0 |
| | 2000h | 0 | 0 | 0 | 0 | 0 | 0 | 0 |
| | 2500h | 0 | 0 | 0 | 0 | 0 | 0 | 0 |
| | 3000h | 0 | 0 | 1 | 1 | 3 | 4 | 0 |

Fig. shows a schematic sectional view of a part of the semiconductor device having multi wiring layers coated and sealed by the curable resin composition of the present invention. An $SiO_2$ insulating layer is 12 formed on a silicon semiconductor substrate 10. A first aluminum wiring layer 14 with a predetermined pattern is formed on the $SiO_2$ insulating layer 12. A first protective film 16 is formed on the first aluminum wiring layer 14 by applying the curable resin composition of the present invention through a spinner and baking at 250°C for 60 minutes. A second aluminum wiring layer 18 with a predetermined pattern is formed on the first protective film 16. Predetermined portions of the first and second aluminum wiring layers 14 and 18 are electrically connected through via holes to form a predetermined wiring circuit. The via holes are formed by applying a positive resist with a via hole patterning on the first protective layer 16, subjecting the positive resist to plasma etching with a reactive gas of $CF_4$-$O_2$ and removing the positiive resist through plasma asher using a reactive gas of $O_2$. A second protective film 20 is formed on the second aluminum wiring layer 18 in the same manner as the first protective film 16.

0237255

<u>Claims:</u>

1. A curable resin composition comprising at least a cycloaliphatic ether oligomer represented by the general formula (I):

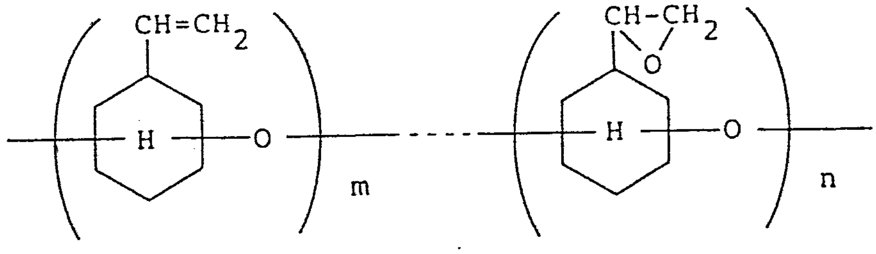

(I)

wherein m and n are each 0 to 30 and $2<m+n\leq30$, and a crosslinking agent selected from: a phenolic resin represented by the general formula (II):

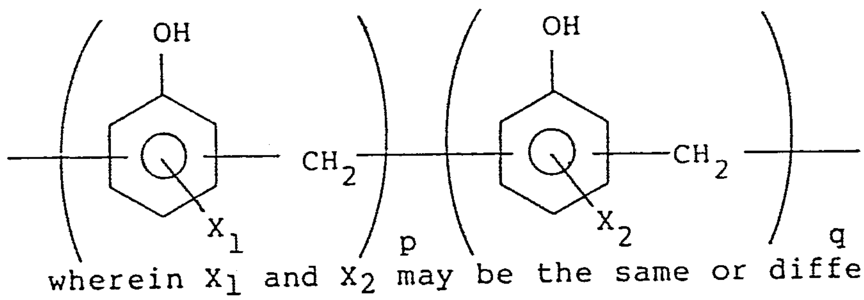

(II)

wherein $X_1$ and $X_2$ may be the same or different from each other and each stands for H, $CH_3$, $C(CH_3)_3$, OH, $NH_2$, COOH, SH, $SO_3H$, $CH_2OH$, Br, Cl,

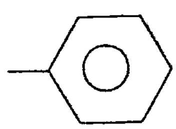

,

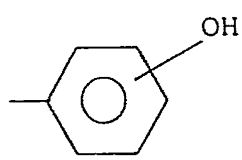

,

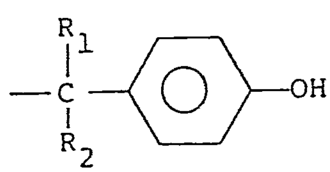

(wherein $R_1$ and $R_2$ are H, $CH_3$ or $CF_3$) and p and q are each 0 to 10 and $1<p+q\leq10$;

a p-hydroxylstyrene polymer or copolymer represented by the general formula (III):

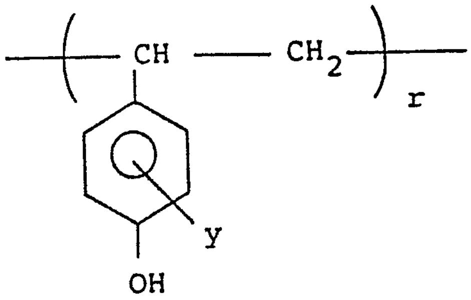

(III)

wherein y is H, $NH_2$, $SO_3H$, Br or Cl and r is 5 to 300;

a compound having at least one N-substituted maleimide bonding or a Diels-Alder adduct thereof; a compound having at least one allyl or propenyl group and at least one hydroxyl group; and 2,4-diamino-6-vinyl-s-triazine.

2. A curable resin composition according to claim 1,

wherein said crosslinking agent of phenolic resin represented by the general formula (II) is at least one condensate prepared by condensing phenol, O-cresol, biphenol, bisphenol F, bisphenol A or trifluoromethylbisphenol A with formaldehyde in the presence of an acid catalyst such as hydrochloric or oxalic acid.

3. A curable resin composition according to claim 1, wherein said crosslinking agent of p-hydroxylstyrene polymer or copolymer represented by the general formula

(III) is at least one selected from p-hydroxylstyrene polymer, 4-hydroxy-4'-biphenylvinyl polymer and copolymers of p-hydroxylstyrene or 4-hydroxy-4'-biphenylvinyl with styrene, maleic acid, butadiene and maleimide.

4. A curable resin composition according to claim 1, wherein said crosslinking agent of the compound having at least one N-substituted maleimide bonding or a Diels-Alder adduct thereof is at least one selected from N-substituted phenylmaleimide and compounds represented by the following formula:

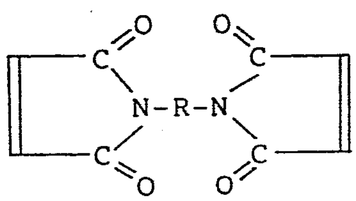

wherein R stands for an alkylene or arylene group or a bivalent organic group substituted thereby.

5. A curable resin composition according to claim 1, wherein said crosslinking agent of the compound having at least one allyl or propenyl group and at least one hydroxyl group is at least one selected from

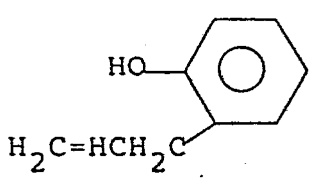

and

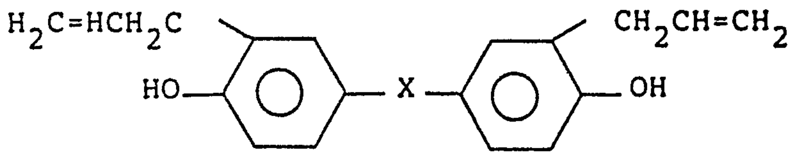

wherein -x- is an isopropylene or methylene group, -o- or nothing.

6. A semiconductor device obtained by coating and sealing at least a part of a semiconductor element and a lead wire with a thermosetting resin composition comprising at least a cycloaliphatic ether oligomer represented by the general formula (I):

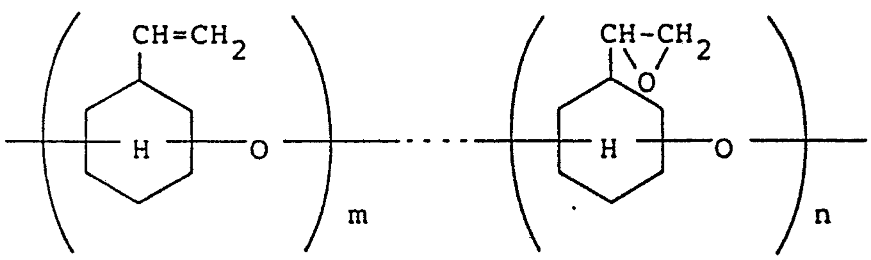

wherein m and n are each 0 to 30 and $2<m+n\leq 30$, and a crosslinking agent selected from: a phenolic resin represented by the general formula (II):

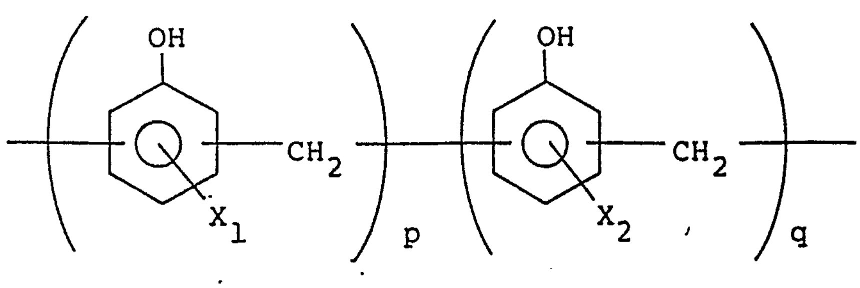

(II)

wherein $X_1$ and $X_2$ may be the same or different from each other and each stands for H, $CH_3$, $C(CH_3)_3$, OH, $NH_2$, COOH, SH, $SO_3H$, $CH_2OH$, Br, Cl,

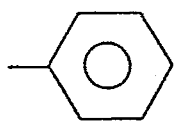 , 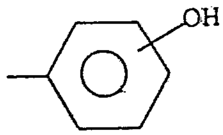 , 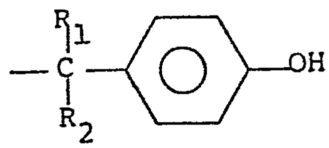

(wherein $R_1$ and $R_2$ are H, $CH_3$ or $CF_3$) and p and q are each 0 to 10 and $1<p+q\leq 10$;

a p-hydroxylstyrene polymer or copolymer represented by the general formula (III):

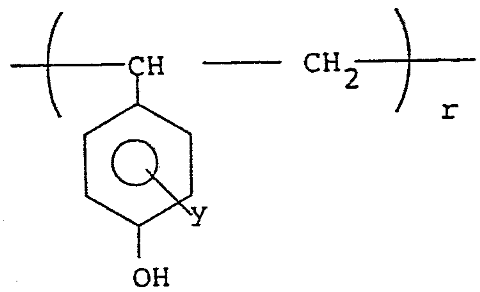 (III)

wherein y is H, $NH_2$, $SO_3H$, Br or Cl and r is 5 to 300;

a compound having at least one N-substituted maleimide bonding or a Diels-Alder adduct thereof.; a compound having at least one allyl or propenyl group and at least one hydroxyl group; and 2,4-diamino-6-vinyle-s-triazine.

7. A semiconductor device obtained by coating and sealing at least a part of a semiconductor element and a lead wire with a curable resin composition according to any of claims 1 to 5.

FIGURE